# EUROPEAN PATENT APPLICATION

(11) **EP 4 672 921 A1**
(43) Date of publication of application: **31.12.2025**
(21) Application number: 25168584.8
(22) Date of filing: 04.04.2025
(51) Int. Cl.: H10F 71/00, H10F 77/70, H10F 10/14, H10F 10/165

(54) **METHOD FOR PREPARING TOPCON SOLAR CELL AND TOPCON SOLAR CELL**

(30) Priority: 26.06.2024 CN 202410842148
(71) Applicant: Jinko Solar (Haining) Co., Ltd., Haining City, Zhejiang 314415 (CN)
(72) Inventor: LIU, Feng, 314415 Haining (CN); ZHANG, Yuanfang, 314415 Haining (CN); WANG, Zhao, 314415 Haining (CN); YANG, Jie, 314415 Haining (CN); ZHENG, Peiting, 314415 Haining (CN); ZHANG, Xinyu, 314415 Haining (CN)
(74) Representative: Haseltine Lake Kempner LLP

(57) **Abstract**

The present application provides a method for preparing a bifacial TOPCON cell and a bifacial TOPCON cell. The preparation method includes steps of double-sided texturing the silicon wafer multiple times (S1, S3, S7 or S1, S3, S9). Polysilicon (5) is deposited on the front side, and then phosphorus diffusion is performed to form a doped polysilicon layer (7) and a phosphosilicate glass (6); alternatively, the phosphorus diffusion is performed to form the phosphorus diffused layer (13) and the phosphosilicate glass (6'). Laser grooving is performed to form localized emitters (S6). After third double-sided texturing on the silicon wafer (S7, S9), the double-sided rounding is performed.

## Description

### TECHNICAL FIELD

The present application relates to the technical field of photovoltaic cells, and specifically to a method for preparing a TOPCON cell and a TOPCON cell.

### BACKGROUND

TOPCON cell, whose full name is Tunnel Oxide Passivated Contact cell, is a new type of cell technology proposed in 2013 and based on the manufacture of an N-type silicon wafer, which can improve the efficiency of solar cells by addressing the issue of cell carrier selective passivation contact. At present, the efficiency of mass-produced TOPCON cells has exceeded 25%. However, existing technology still faces certain challenges in improving the bifaciality factor of TOPCON cells.

The bifaciality factor of existing TOPCON cells is low and difficult to be improved.

Therefore, there is an urgent need to provide a method for preparing a TOPCON cell and a TOPCON cell, which can improve bifaciality factor and efficiency of the cell, save process, and reduce costs.

### SUMMARY

In view of this, the present application provides a method for preparing a TOPCON cell, including steps of:
providing a silicon wafer having a front side and a back side disposed opposite to each other in a first direction, the first direction being a thickness direction of the silicon wafer,
first double-sided texturing the silicon wafer to form first textured surfaces on the front side and the back side,
performing boron diffusion on the back side to form a boron diffused layer and a borosilicate glass,
second double-sided texturing the silicon wafer to form a second textured surface on the front side and the back side,
depositing polysilicon on the front side, followed by performing phosphorus diffusion to form a doped polysilicon layer and a phosphorosilicate glass, or directly performing phosphorus diffusion on the front side to form a phosphorus diffused layer and the phosphorosilicate glass,
laser grooving to form a localized emitter, and
third double-sided texturing the silicon wafer to remove the phosphorosilicate glass and the borosilicate glass and form third textured surfaces on the front side and the back side, or third double-sided texturing and double-sided rounding the silicon wafer to form rounded-textured surfaces on the front side and the back side.

Optionally, a condition for the first double-sided texturing includes a temperature of 65°C to 70°C and a time period of 350 seconds to 400 seconds,
a condition for the second double-sided texturing includes a temperature of 65°C to 70°C and a time period of 350 seconds to 400 seconds, and/or
a condition for the third double-sided texturing includes a temperature of 70°C to 75°C and a time period of 400 seconds to 450 seconds.

Optionally, the first textured surface has a thickness h1 in the first direction and a spire angle α, where 2.5 µm≤h1≤3.5 µm and 40°≤α≤45°,
the second textured surface has a thickness h2 in the first direction and a spire angle β, where 2.5 µm≤h2≤3.5 µm and 40°≤β≤45°, and/or
the third textured surface has a thickness h3 in the first direction and a spire angle θ, where 3 µm≤h3≤4 µm and 45°≤θ≤50°.

Optionally, a condition for performing the boron diffusion on the back side to form the boron diffused layer and the borosilicate glass includes a temperature of 950°C to 1000°C and a time period of 4000 seconds to 5000 seconds.

Optionally, the boron diffused layer has a thickness of 700 nm to 1000 nm in the first direction; the borosilicate glass has a thickness of 100 nm to 150 nm in the first direction.

Optionally, a condition for performing the phosphorus diffusion on the front side to form the phosphorus diffused layer and the phosphorosilicate glass includes a temperature of 900°C to 950°C and a time period of 3000 seconds to 4000 seconds;
a thickness of the phosphorosilicate glass in the first direction is in a range from 60 nm to 100 nm;
a thickness of the phosphorus diffused layer in the first direction is in a range from 600 nm to 1000 nm.

Optionally, depositing polysilicon on the front side, followed by performing phosphorus diffusion to form the doped polysilicon layer and the phosphorosilicate glass includes steps of:
depositing a polysilicon layer on the front side, and
performing the phosphorus diffusion to form the doped polysilicon layer and the phosphorosilicate glass;
a condition for depositing the polysilicon layer on the front side includes a time period of 300 seconds to 360 seconds and a temperature of 600°C to 650°C; a thickness of the polysilicon layer in the first direction is in a range from140 nm to 155 nm;
a thickness of the doped polysilicon layer in the first direction is in a range from 130 nm to 150 nm.

Optionally, laser grooving to form the localized emitter includes steps of:
applying laser to the front side, and
applying laser to the back side;
the silicon wafer includes a first region and a second region; applying the laser to the front side forms a doped polysilicon emitter or a phosphorus diffused emitter in the first region of the front side; applying the laser to the back side forms a boron diffused emitter in the first region of the back side;
the first region of the front side occupies 3% to 30% of the front side; the first region of the back side occupies 5% to 50% of the back side.

Optionally, the double-sided rounding includes steps of:
cleaning the silicon wafer in an ozone oxidation solution, and
cleaning the silicon wafer in an acid washing solution;
a radius of curvature of the rounded-textured surface is r, where 0.5 µm≤r≤1.2 µm.

In another aspect, the present application provides a TOPCON cell prepared by the method as described above.

Compared with the prior art, the method for preparing the TOPCON cell and the TOPCON cell provided in the present application achieve at least the following beneficial effects.

According to the steps of the method for preparing the TOPCON cell provided in the present application, the silicon wafer is first double-sided textured to form first textured surfaces on the front side and the back side, which facilitates boron diffusion on the back side later. Boron diffusion is performed on the back side to form the boron diffused layer and the borosilicate glass, and the borosilicate glass protects the boron diffused layer during the laser grooving. The silicon wafer is then second double-sided textured, due to the borosilicate glass disposed on the back side blocking the second texturing, the second double-sided texturing is equivalent to single-sided texturing on the front side of the silicon wafer, which eliminates an alkali polishing process and save costs.

During the manufacturing of TOPCON cells, there is a need to accurately control key process parameters, such as the thickness of the tunnel oxide layer and the deposition quality of the doped polysilicon layer. Even slight variations in these parameters may significantly affect the bifaciality factor of the cell. However, existing manufacturing technology and equipment levels still fall short of fully meeting the demands for high-precision controls, thus constraining the further improvement of the bifaciality factor of TOPCON cells. According to the method for preparing the TOPCON cell provided in the present application, polysilicon is first deposited on the front side, and then phosphorus diffusion is performed to form the doped polysilicon layer and the phosphorosilicate glass. The phosphorosilicate glass protects the doped polysilicon layer during the laser process, thereby providing a basis for formation of the doped polysilicon emitter. Alternatively, the phosphorus diffusion is performed directly on the front side to form the phosphorus diffused layer and the phosphorosilicate glass, so that the step of depositing the polysilicon layer is omitted, thereby reducing costs, and lowering the influences of the process parameters on the bifaciality factor. The phosphorosilicate glass and the borosilicate glass can replace the existing mask, thereby omitting the mask process, further simplifying the process flows, and reducing costs, while effectively avoiding the potential impact of ion bombardment on the polysilicon layer during the mask process and the mechanical damage caused by laser grooving.

Laser grooving is performed to form a localized emitter, wherein a doped polysilicon emitter electrode or a phosphorus diffused emitter electrode is formed on the front side, and a boron diffused emitter electrode is formed on the back side. The localized emitters contribute to reducing the recombination caused by the diffusion layer and increasing the open-circuit voltage of the cell. The silicon wafer is third double-sided textured to remove the phosphorosilicate glass and the borosilicate glass, and form the third textured surface on the front side and the back side. The double-sided textured surface structure on the front side and the back side of the silicon wafer further improves the bifaciality factor and saves costs.

According to the existing TOPCON cells, in order to achieve a high bifaciality factor, the back side typically employs a textured structure, but hydrogen escaping during high temperature process may affect the passivation effect at the interface between the textured structure and the tunnel oxide layer. In contrast, by performing three times of double-sided texturing, the method for preparing the TOPCON cell provided in the present application omits the alkali polishing process required for single-sided texturing, further improves the bifaciality factor, and saves costs. In the prior art, in order to ensure sufficient passivation effect for TOPCON cells, a relatively thick passivation layer is usually adopted. However, the thick passivation layer or a special structure may block transmission of partial light, thereby reducing the photoelectric conversion efficiency on the back side of the cell, and thus reducing the bifaciality factor. According to the method for preparing the TOPCON cell provided in the present application, the silicon wafer is subjected to third double-sided texturing and double-sided rounding to form the rounded-textured surfaces on the front side and the back side, which enhances the passivation effect and effectively reduces the light transmission inside the silicon wafer, thereby improving the light absorption capacity and carrier generation capacity of the cell. The TOPCON cell provided in the present application can simultaneously significantly improve open-circuit voltage, fill factor, and bifaciality factor.

Certainly, it is not necessary for any product of the present application to achieve all the technical effects described above simultaneously.

Other features and advantages of the present application will become apparent from the following detailed description of exemplary embodiments of the present application, with reference to the accompanying drawings.

### BRIEF DESCRIPTION OF THE DRAWINGS

The accompanying drawings, which are incorporated in and constitute a part of the specification, illustrate embodiments of the present application. Together with their description, they explain the principles of the present application.
FIG. 1 shows a flowchart of a method for preparing a TOPCON cell according to the present application.
FIG. 2 shows a flowchart of another method for preparing a TOPCON cell according to the present application.
FIG. 3 shows a flowchart of yet another method for preparing a TOPCON cell according to the present application.
FIG. 4 is a schematic structural view of a first region and a second region.
FIG. 5 is a schematic structural view of a TOPCON cell according to the present application.

### Reference signs:

100: silicon wafer; 1: first textured surface; 2: boron diffused layer; 3: borosilicate glass; 4: second textured surface; 5: polysilicon layer; 6 (or 6'): phosphorosilicate glass; 7: doped polysilicon layer; 8: doped polysilicon emitter; 9: boron diffused emitter; 10: third textured surface; 11: front side; 12: back side; 13: phosphorus diffused layer; 14: phosphorus diffused emitter; 15: rounded-textured surface; 16: first region; 17: second region; 18: passivation layer; 19: anti-reflection layer; y: first direction.

### DETAILED DESCRIPTION

Various exemplary embodiments of the present application will now be described in detail with reference to the accompanying drawings. It should be noted that the relative arrangements of components and steps, as well as numerical expressions and values, set forth in these embodiments do not limit the scope of the present application, unless specifically stated otherwise.

The following description of at least one exemplary embodiment is merely illustrative and is not intended to limit the present application and its application or use.

Techniques, methods, and apparatuses known to those of ordinary skill in the relevant art are not described in detail, but should be considered as part of the specification where appropriate.

In all examples shown and discussed herein, any specific values should be construed as merely exemplary and not as limiting. Accordingly, other examples of exemplary embodiments may have different values.

It should be noted that like reference signs and letters refer to like items in the following drawings. Therefore, once an item is defined in one drawing, it does not need to be further discussed in subsequent drawings.

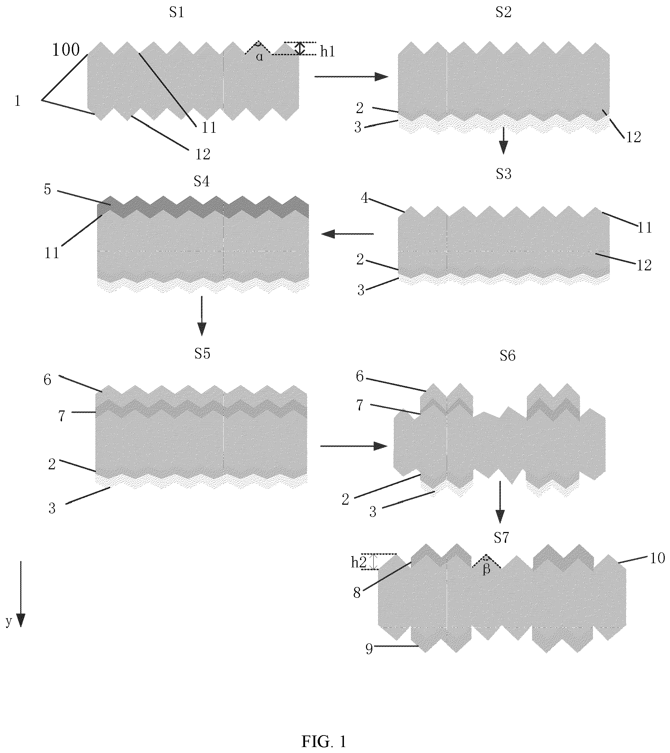

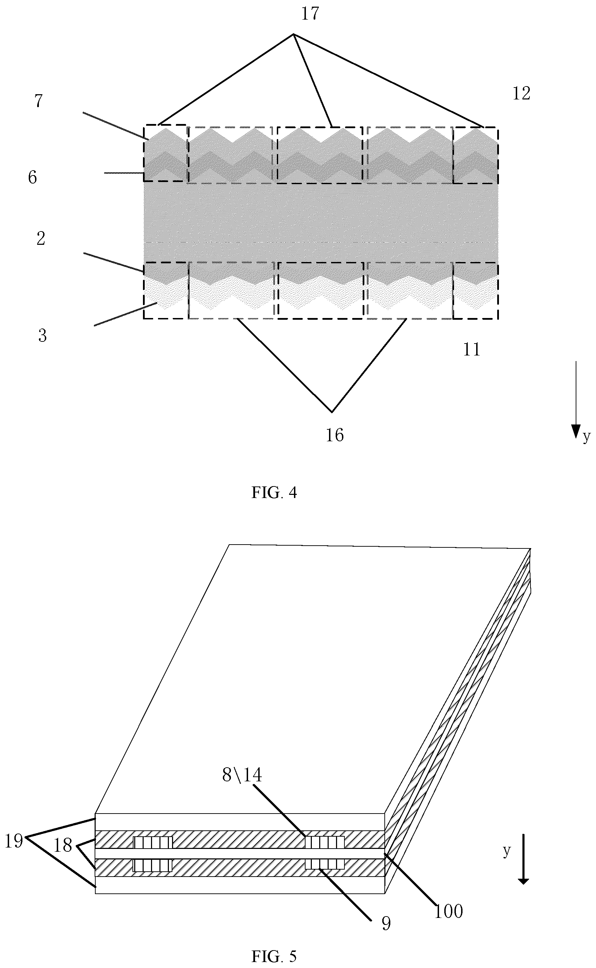

Referring to FIGS. 1 to 4, the present application provides a method for preparing a TOPCON cell, including steps of:
providing a silicon wafer 100 including a front side 11 and a back side 12 disposed opposite to each other in a first direction y, the first direction y being a thickness direction of the silicon wafer 100;
S1: first double-sided texturing the silicon wafer 100 to form first textured surfaces 1 on the front side 11 and the back side 12;
S2: performing boron diffusion on the back side 12 to form a boron diffused layer 2 and a borosilicate glass 3;
S3: second double-sided texturing the silicon wafer 100 to form a second textured surface 4 on the front side 11 and the back side 12;
S4: depositing polysilicon on the front side 11, followed by S5: performing phosphorus diffusion to form a doped polysilicon layer 7 and a phosphorosilicate glass 6; alternatively, S8: directly performing phosphorus diffusion on the front side 11 to form a phosphorus diffused layer 13 and the phosphorosilicate glass 6;
S6: laser grooving to form a localized emitter; and
S7: third double-sided texturing the silicon wafer 100 to remove the phosphorosilicate glass 6 and the borosilicate glass 3, and form third textured surfaces 10 on the front side 11 and the back side 12; alternatively, S9: third double-sided texturing and double-sided rounding the silicon wafer 100 to form a rounded-textured surface 15 on the front side 11 and the back side 12.

Specifically, the present application provides a method for preparing a TOPCON cell, which includes the following steps.

The silicon wafer 100 including the front side 11 and the back side 12 disposed opposite to each other in the first direction y is provided, the first direction y being the thickness direction of the silicon wafer 100.

Referring to FIGS. 1 to 3, S1: the silicon wafer 100 is first double-sided textured to form the first textured surfaces 1 on the front side 11 and the back side 12, which facilitates boron diffusion on the back side 12, removes stains from the surfaces of the silicon wafer 100, reduces the occurrence of defective products, and enlarges the surface area of the silicon wafer 100, also meaning an increase in the area of the PN junction. By forming the undulating first textured surface 1, it can generate a light trapping effect, which enhances the absorption of the silicon wafer 100 to sunlight, reduces light reflectivity of the silicon surface, increases the short-circuit current, and improves the photoelectric conversion efficiency. It should be noted that the main purpose of texturing is to form a pyramid-shaped textured structure on the surface of the silicon wafer 100 through specific chemical and physical processes, which increases the absorption of light and improves the power generation efficiency of photovoltaic cells. Texturing process is primarily based on the anisotropic corrosion characteristics of silicon in an alkaline solution with a low concentration. Under treatment at certain concentrations, temperatures, and time periods, silicon (Si) chemically reacts with the alkaline solution (typically NaOH solution) to form a pyramid-shaped textured structure on the surface of silicon wafer 100. This textured structure can increase the absorption of the silicon wafer 100 to sunlight and reduce reflectivity through the light trapping effect, and enlarge the surface area of the silicon wafer 100, thereby increasing the area of the P-N junction, and thus improving power generation efficiency.

During the texturing, the silicon wafer is initially cleaned by using NaOH solution and H₂O₂ solution to remove organic contaminants and metal impurities on the surface of the silicon wafer 100, as well as to eliminate the mechanically damaged layer caused by the wire cutting process of the silicon wafer 100. After that, an appropriate amount of NaOH solution and a texturing additive are added to the texturing tank. The additive can improve the wetting effect of silicon wafer 100 with the NaOH solution, thereby enhancing the anisotropy of corrosion. Silicon reacts with the NaOH solution to generate sodium silicate (Na₂SiO₃) and hydrogen gas (H₂), i.e., Si+2NaOH+H₂O=Na₂SiO₃+2H₂ ↑ . Subsequently, further processing steps, such as pure water washing, drying, etc., are required to remove residual chemicals and moisture, obtaining the final pyramidal textured surface.

Referring to FIGS. 1 to 3, S2: boron diffusion is performed on the back side 12 to form the boron diffused layer 2 and the borosilicate glass 3, forming a thick borosilicate glass 3 layer, which replaces the mask to protect a first region 16 in the laser process, thereby saving the mask process, reducing costs, and effectively avoiding the potential impact of ion bombardment in the mask process.

It should be noted that boron, as a trivalent element, can introduce additional electron holes when diffused into the silicon wafer 100, thereby altering the electrically conductive performance of the silicon wafer 100. Through the boron diffusion process, boron atoms can enter the interior of the silicon wafer to form the boron diffused layer 2, which can adjust the electrical conductivity and resistivity of the crystal. The boron diffusion begins with coating a thin film on the surface of the silicon wafer, typically using silicon dioxide (SiO₂) as a material of the thin film. The function of this thin film is to prevent boron atoms from directly diffusing from the surface of the silicon wafer into the interior, and ensure even distribution of the boron atoms on the thin film. The silicon wafer coated with the thin film is placed into a diffusion furnace, where a boron source (such as BBr₃) is heated to evaporate or sublime. The resulting boron atoms pass through the thin film and diffuse into the silicon wafer to form the boron diffused layer after the diffusion source is heated to a certain temperature. During the boron diffusion, the boron atoms chemically react with silicon atoms on the surface of the silicon wafer to form borosilicate compounds, which melt at high temperatures to form a borosilicate glass layer 3. During the boron diffusion, the boron atoms not only diffuse into the interior of the silicon wafer to form the boron diffused layer 2, but also react with silicon atoms on the surface of the silicon wafer to form borosilicate compounds. These borosilicate compounds can melt at high temperatures to form the borosilicate glass layer 3.

Referring to FIGS. 1 to 3, S3: the silicon wafer 100 is second double-sided textured to form a second textured surface 4 on the front side 11 and the back side 12. The back side 12 of the silicon wafer 100 has the borosilicate glass 3, which blocks the second texturing by losing a certain thickness. Thus, the second double-sided texturing is equivalent to performing single-sided texturing on the front side 11 of the silicon wafer 100 due to the presence of the borosilicate glass 3, thereby eliminating an additional alkali polishing process required for single-sided texturing, and thus saving costs.

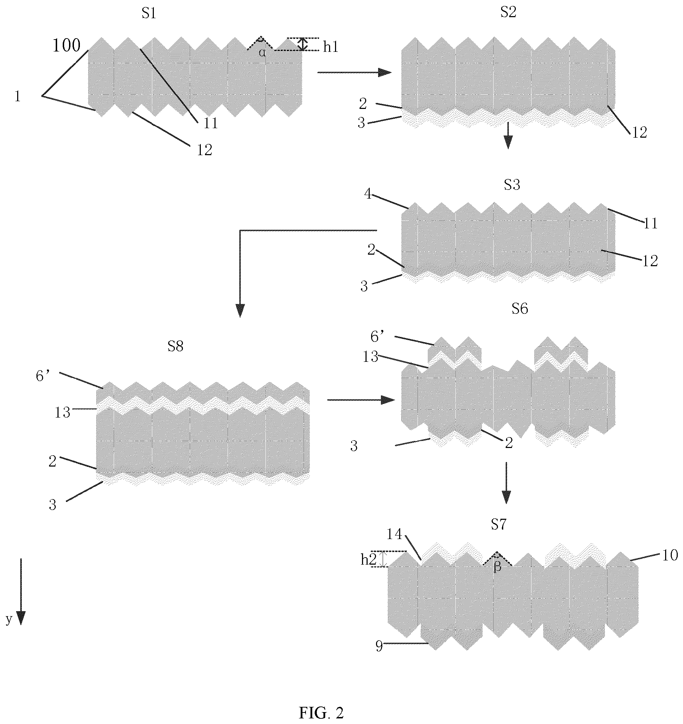

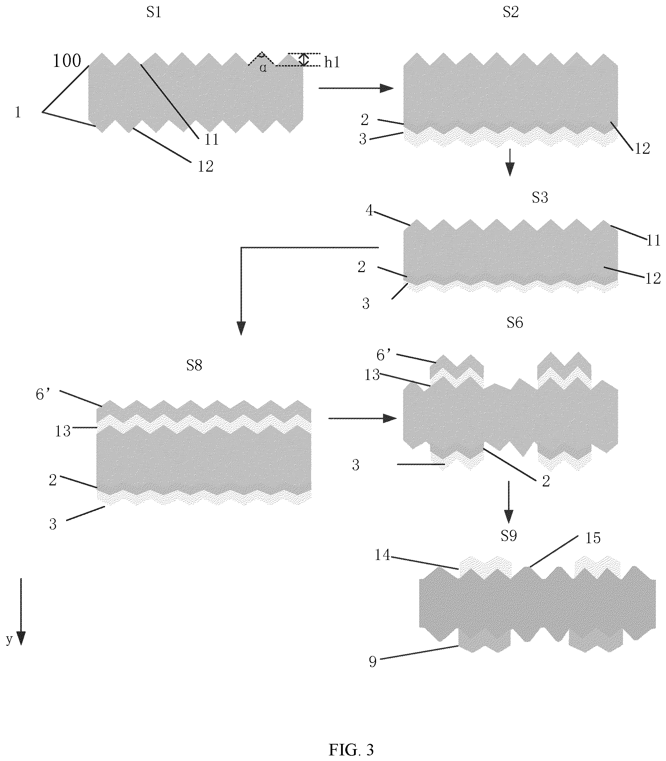

Referring to FIG. 1, S4: Polysilicon is deposited on the front side 11, and then S5: phosphorus diffusion is performed to form the doped polysilicon layer 7 and the phosphorosilicate glass 6. After forming the polysilicon layer 5, the doped polysilicon layer 7 and the thick phosphorosilicate glass 6 layer are formed by the phosphorus diffusion. The phosphorosilicate glass 6 layer replaces the mask to protect the first region 16 in the laser process, saving the mask process, reducing costs, and effectively avoiding the impact of ion bombardment on the doped polysilicon layer in the mask process and the mechanical damage. Alternatively, referring to FIGS. 2 and 3, S8: the phosphorus diffusion is performed directly on the front side 11 to form the phosphorus diffused layer 13 and the phosphorosilicate glass 6. By omitting the step of depositing the polysilicon layer 5 and thus not forming the doped polysilicon layer 7, the combination of photogenerated carriers with single electrons caused by the phosphorus diffusion can be reduced during the generation and conduction of photogenerated carriers, that is, Auger recombination can be reduced, thereby increasing the open-circuit voltage.

It should be noted that the phosphorus diffusion involves reacting a phosphorus source (such as POCl₃) with the surface of the silicon wafer 100 to generate phosphorus atoms, and diffusing the phosphorus atoms into the interior of the silicon wafer 100, thereby forming a region rich in phosphorus atoms on the surface of the silicon wafer, that is, the phosphorus diffused layer 13. During the phosphorus diffusion, the phosphorus source reacts with oxygen to generate P₂O₅, which can react with the surface of silicon to form the phosphorosilicate glass 6 (PSG). PSG mainly consists of SiO₂ and PO₄, which typically appears a white or gray thin film covering the surface of the silicon wafer.

Specifically, the phosphorus diffusion process is as follows. A clean silicon wafer is used as a substrate to ensure that the surface is free of impurities and contaminants. A layer of the phosphorus source (such as POCl₃) is coated on the surface of silicon wafer, or a phosphorus source in a gaseous form is used for the diffusion. The silicon wafer coated with the phosphorus source is placed into a high-temperature furnace for the diffusion treatment. The phosphorus source decomposes and releases phosphorus atoms, which diffuse into the interior of the silicon wafer to form the phosphorus diffused layer 13. During the phosphorus diffusion, the phosphorus source (such as POCl₃) reacts with oxygen to generate P₂O₅, which can react with the surface of silicon to form the phosphorosilicate glass 6 (PSG). As the reaction progresses, the phosphorosilicate glass 6 layer is gradually formed on the surface of the silicon wafer 100, covering the entire diffusion area. It should be noted that the process of formation of the doped polysilicon 7 (n-poly) by the phosphorus diffusion is specifically as follows: through chemical reactions or physical means (such as evaporation, sublimation, etc.), the phosphorus source (such as POCl₃) is in a gaseous form during the diffusion process; the phosphorus source is uniformly coated on the surface of the silicon wafer 100 to ensure sufficient contact between the phosphorus source and the silicon wafer 100; at certain temperatures, the phosphorus atoms generated by the decomposition of the phosphorus source gain sufficient energy to overcome the potential barrier in the silicon lattice and diffuse into the interior of the silicon wafer 100; the phosphorus atoms are bonded with the silicon atoms to form the doped polysilicon 7 (n-poly). In this process, the doping of phosphorus atoms changes the electrical properties of the silicon wafer 100, making it to exhibit n-type electrical conductivity. Due to the doping of phosphorus atoms, the n-poly layer has n-type electrical conductivity and can provide free electron carriers.

Referring to FIGS. 1 to 3, S6: laser grooving is performed to form a localized emitter. The localized emitter contributes to reducing Auger recombination and increasing the open-circuit voltage.

It should be noted that the laser grooving technology involves focusing a high-energy laser beam generated by a laser onto and irradiating a cell surface (usually a silicon wafer 100), making the cell surface to be locally heated and melt, thereby forming tiny holes or a specific structure in the cell. This hole or structure serves as a localized emitting electrode to optimize the performance of the cell. The specific process is as follows: First, the surface of the silicon wafer 100 is cleaned to ensure that it is free of impurities and contaminants; a specific region of the silicon wafer 100 is then irradiated with a high-energy laser beam; the high energy focusing and orientation of the laser beam makes the irradiated region to heat up rapidly and then be melt, forming tiny holes or a specific structure in the silicon wafer 100, thereby forming a localized emitting electrode. These localized electrodes can optimize the collection and distribution of current, reducing resistance loss, and improving cell efficiency. After formation of the localized emitter electrodes, other processing steps such as cleaning, annealing, etc. may be required to further optimize the performance of the cell.

Referring to FIG. 2, S7: the silicon wafer 100 is third double-sided textured to remove the phosphorosilicate glass 6 and the borosilicate glass 3, and form third textured surfaces 10 on the front side 11 and the back side 12. The third texturing is performed to the doped polysilicon layer 7 and the phosphorosilicate glass 6 that have been destroyed by laser grooving in a second region 17, or the silicon wafer 100 exposed after removing the borosilicate glass 3, thereby obtaining a local textured surface different from the first textured surface 1 and the second textured surface 4. The nonuniform sizes of the textured surfaces help to increase light absorption, and reduce light transmission and light reflection. The double-sided textured surfaces improve the bifaciality factor. Alternatively, referring to FIG. 3, S9: the silicon wafer 100 is third double-sided textured and double-sided rounded to form a rounded-textured surface 15 on the front side 11 and the back side 12. The rounded-textured surface 15 is closer to a planar structure, which is more conducive to the deposition of a passivation layer 18, improving the uniformity of the deposition, and enhancing the passivation effect. In addition, the rounded-textured surface 15 can also effectively reduce the light transmission inside the silicon substrate, improve the light absorption and carrier generation in the cell, and further improve the light absorption and conversion efficiency of the cell.

It should be noted that, referring to FIG. 1, S4: polysilicon is deposited on the front side 11, and then S5: phosphorus diffusion is performed to form a doped polysilicon layer 7 and a phosphorosilicate glass 6. After forming a polysilicon layer 5, the doped polysilicon layer 7 and the thick phosphorosilicate glass 6 layer are formed by the phosphorus diffusion. The phosphorosilicate glass 6 layer replaces the mask to protect the first region 16 in the laser process, saving the mask process, reducing costs, and effectively avoiding the impact of ion bombardment on the doped polysilicon layer in the mask process and the mechanical damage. Alternatively, referring to FIGS. 2 and 3, S8: the phosphorus diffusion is performed directly on the front side 11 to form the phosphorus diffused layer 13 and the phosphorosilicate glass 6. By omitting the step of depositing the polysilicon layer 5 and thus not forming the doped polysilicon layer 7, the combination of photogenerated carriers with single electrons caused by the phosphorus diffusion can be reduced during generation and conduction of photogenerated carriers, that is, Auger recombination can be reduced, thereby increasing the open-circuit voltage.

It should be noted that, referring to FIGS. 1 and 2, S7: the silicon wafer 100 is third double-sided textured to remove the phosphorosilicate glass 6 and the borosilicate glass 3, and form the third textured surfaces 10 on the front side 11 and the back side 12. The third texturing is performed to the doped polysilicon layer 7 and the phosphorosilicate glass 6 that have been destroyed by laser grooving in a second region 17, or the silicon wafer 100 exposed after removing the borosilicate glass 3, thereby obtaining a local textured surface different from the first textured surface 1 and the second textured surface 4. The nonuniform sizes of the textured surfaces help to increase light absorption, and reduce light transmission and light reflection. The double-sided textured surfaces improve the bifaciality factor. Alternatively, referring to FIG. 3, S9: the silicon wafer 100 is third double-sided textured and double-sided rounded to form a rounded-textured surface 15 on the front side 11 and the back side 12. The rounded-textured surface 15 is closer to a planar structure, which is more conducive to the deposition of a passivation layer 18, improving the uniformity of the deposition, and enhancing the passivation effect. In addition, the rounded-textured surface 15 can also effectively reduce the light transmission inside the silicon substrate, improve the light absorption and carrier generation in the cell, and further improve the light absorption and conversion efficiency of the cell.

Optionally, referring to FIG. 1, the present application provides a method for preparing a TOPCON cell, which includes steps of: providing a silicon wafer 100 including a front side 11 and a back side 12 disposed opposite to each other in a first direction y, the first direction y being a thickness direction of the silicon wafer 100;
S1: first double-sided texturing the silicon wafer 100 to form first textured surfaces 1 on the front side 11 and the back side 12;
S2: performing boron diffusion on the back side 12 to form a boron diffused layer 2 and a borosilicate glass 3;
S3: second double-sided texturing the silicon wafer 100 to form a second textured surface 4 on the front side 11 and the back side 12;
S4: depositing polysilicon on the front side 11, followed by S5: performing phosphorus diffusion to form a doped polysilicon layer 7 and a phosphorosilicate glass 6;
S6: laser grooving to form a localized emitter; and
S7: third double-sided texturing the silicon wafer 100 to remove the phosphorosilicate glass 6 and the borosilicate glass 3, and form third textured surfaces 10 on the front side 11 and the back side 12.

Optionally, referring to FIG. 2, the present application further provides a method for preparing a TOPCON cell, which includes steps of: providing a silicon wafer 100 having a front side 11 and a back side 12 disposed opposite to each other in a first direction y, the first direction y being a thickness direction of the silicon wafer 100;
S1: first double-sided texturing the silicon wafer 100 to form first textured surfaces 1 on the front side 11 and the back side 12;
S2: performing boron diffusion on the back side 12 to form a boron diffused layer 2 and a borosilicate glass 3;
S3: second double-sided texturing the silicon wafer 100 to form a second textured surface 4 on the front side 11 and the back side 12;
S8: directly performing phosphorus diffusion on the front side 11 to form a phosphorus diffused layer 13 and a phosphorosilicate glass 6;
S6: laser grooving to form a localized emitter; and
S7: third double-sided texturing the silicon wafer 100 to remove the phosphorosilicate glass 6 and the borosilicate glass 3, and form third textured surfaces 10 on the front side 11 and the back side 12.

Optionally, referring to FIG.3, the present application yet provides a method for preparing a TOPCON cell, which includes steps of: providing a silicon wafer 100 having a front side 11 and a back side 12 disposed opposite to each other in a first direction y, the first direction y being a thickness direction of the silicon wafer 100;
S1: first double-sided texturing the silicon wafer 100 to form first textured surfaces 1 on the front side 11 and the back side 12;
S2: performing boron diffusion on the back side 12 to form a boron diffused layer 2 and a borosilicate glass 3;
S3: second double-sided texturing the silicon wafer 100 to form a second textured surface 4 on the front side 11 and the back side 12;
S8: directly performing phosphorus diffusion on the front side 11 to form a phosphorus diffused layer 13 and a phosphorosilicate glass 6;
S6: laser grooving to form a localized emitter; and
S9: third double-sided texturing and double-sided rounding the silicon wafer 100 to form a rounded-textured surface 15 on the front side 11 and the back side 12.

It should be understood that, according to the steps of the method for preparing the TOPCON cell provided in the present application, S1: the silicon wafer 100 is first double-sided textured to form first textured surfaces 1 on the front side 11 and the back side 12, which facilitates boron diffusion on the back side 12 of the silicon wafer 100. S2: Boron diffusion is performed on the back side 12 to form the boron diffused layer 2 and the borosilicate glass 3, and the borosilicate glass 3 protects the boron diffused layer 2 during the laser grooving. The silicon wafer 100 is then second double-sided textured, due to the borosilicate glass 3 disposed on the back side 12 blocking the second texturing, the second double-sided texturing is equivalent to single-sided texturing on the front side 11 of the silicon wafer 100, which eliminates an additional alkali polishing process and save costs. S4: Polysilicon is first deposited on the front side 11, and then S5: phosphorus diffusion is performed to form the doped polysilicon layer 7 and the phosphorosilicate glass 6. The phosphorosilicate glass 6 protects the doped polysilicon layer 7 during the laser process, thereby providing a basis for formation of the doped polysilicon emitter 8. Alternatively, S8: the phosphorus diffusion is performed directly on the front side 11 to form the phosphorus diffused layer 13 and the phosphorosilicate glass 6, so that the process of depositing the polysilicon layer is omitted, thereby reducing costs. The phosphorosilicate glass 6 and the borosilicate glass 3 replace the existing mask, thereby omitting the mask process, further simplifying the process flows, and reducing costs, while effectively avoiding the potential impact of ion bombardment on the polysilicon layer 5 in the mask process and the mechanical damage caused by laser grooving. S6: Laser grooving is performed to form a localized emitter, wherein a doped polysilicon emitter electrode or a phosphorus diffused emitter electrode is formed on the front side 11, and a boron diffused emitter electrode is formed on the back side 12. The localized emitters contribute to reducing the recombination caused by the diffusion layer and increasing the open-circuit voltage of the cell. S7: The silicon wafer 100 is third double-sided textured to remove the phosphorosilicate glass 6 and the borosilicate glass 3, and form third textured surfaces 10 on the front side 11 and the back side 12. The double-sided textured surface structure on the front side 11 and the back side 12 of the silicon wafer 100 further improves the bifaciality factor and saves costs. S9: The silicon wafer 100 is third double-sided textured and double-sided rounded to form the rounded-textured surface 15 on the front side 11 and the back side 12, which enhances the passivation effect and effectively reduces the light transmission inside the silicon wafer 100, thereby improving the light absorption capacity and carrier generation capacity of the cell. The TOPCON cell provided in the present application can simultaneously significantly improve open-circuit voltage, fill factor, and bifaciality factor.

In some optional embodiments, a condition for the first double-sided texturing includes a temperature of 65°C to 70°C and a time period of 350 seconds to 400 seconds,
a condition for the second double-sided texturing includes a temperature of 65°C to 70°C and a time period of 350 seconds to 400 seconds, and/or
a condition for the third double-sided texturing includes a temperature of 70°C to 75°C and a time period of 400 seconds to 450 seconds.

Optionally, the temperature for the first double-sided texturing can be 65°C, 66°C, 67°C, 68°C, 69°C, 70°C. When the temperature for the first double-sided texturing is greater than 70°C, the anisotropic factor (AF) value of reaction decreases, the continuity of the first textured surface 1 decreases, and the corrosion rate is excessively fast, making it difficult to be controlled. When the temperature for the first double-sided texturing is below 65°C, the corrosion rate is excessively slow, thereby prolonging the texturing period. Therefore, the temperature for the first double-sided texturing ranged from 65°C to 70°C ensures an appropriate corrosion rate, and enhances the continuity and the uniformity of the first textured surface 1.

Optionally, the time period for the first double-sided texturing can be 350 s, 360 s, 364 s, 368 s, 370 s, 373 s, 378 s, 380 s, 383 s, 385 s, 390 s, 396 s, and 400 s. When the time period for the first double-sided texturing is less than 350 s, the duration is relatively short, resulting in uneven growth. When the time period for the first double-sided texturing is more than 400 s, the first double-sided texturing lasts too long, in turn leading to a decrease in the uniformity of the textured structure. Therefore, when the time period of the first double-sided texturing is in a range from 350°C to 400°C, the first textured surface 1 expands and merges outward as the time increases, gradually expanding its volume, and thus resulting in more uniform dimension.

Optionally, the temperature for the second double-sided texturing can be 65°C, 66°C, 67°C, 68°C, 69°C, or 70°C. When the temperature for the second double-sided texturing is greater than 70°C, the anisotropic factor (AF) value of reaction decreases, the continuity of the second textured surface 4 decreases, and the corrosion rate is excessively fast, making it difficult to be controlled. When the temperature for the second double-sided texturing is below 65°C, the corrosion rate is too slow, prolonging the texturing period. Therefore, the temperature for the second double-sided texturing ranged from 65°C to 70°C ensures an appropriate corrosion rate, and enhances the continuity of the second textured surface 4.

Optionally, the time period for the second double-sided texturing can be 350 s, 360 s, 364 s, 368 s, 370 s, 373 s, 378 s, 380 s, 383 s, 385 s, 390 s, 396 s, or 400 s. When the time period for the second double-sided texturing is less than 350 s, the duration is too short, resulting in uneven growth. When the time period for the second double-sided texturing is more than 400 s, the second double-sided texturing lasts too long, in turn leading to a decrease in the uniformity of the textured structure. Therefore, when the time period of the second double-sided texturing is in a range from 350°C to 400°C, the second textured surface 4 expands and merges outward as the time increases, gradually expanding its volume, and thus resulting in more uniform dimension.

It should be noted that, during the third double-sided texturing, the third textured surface 10 cannot be formed in the first region 16 due to the protection by the phosphorosilicate glass 6 and the borosilicate glass 3 during the laser grooving. Therefore, the third double-sided texturing is localized texturing. The third texturing is performed to the doped polysilicon layer 7 and the phosphorosilicate glass 6 that have been destroyed with laser in the second region 17, or the silicon substrate exposed after removing the borosilicate glass 3, thereby obtaining a local textured surface different from the first textured surface 1 and the second textured surface 4. The nonuniform pyramids help to increase light absorption, and reduce light transmission and light reflection. The double-sided textured surfaces on the front side 11 and back side 12 of the silicon wafer 100 improve the bifaciality factor.

In some optional embodiments, referring to FIGS. 1 to 3, the first textured surface 1 has a thickness h1 in the first direction and a spire angle α, where 2.5 µm≤h1≤3.5 µm, 40°≤α≤45°; the second textured surface 4 has a thickness h2 in the first direction and a spire angle β, where 2.5 µm≤h2≤3.5 µm, 40°≤β≤45°, and/or the third textured surface 10 has a thickness h3 in the first direction and a spire angle θ, where 3 µm≤h3≤4 µm, 45°≤θ≤50°.

Optionally, the thickness h1 of the first textured surface 1 in the first direction y can be 2.5 µm, 2.6 µm, 2.7 µm, 2.8 µm, 2.9 µm, 3.0 µm, 3.1 µm, 3.2 µm, 3.3 µm, 3.4 µm, or 3.5 µm. When h1>3.5 µm, the height of the first textured surface 1 is excessively large, which can easily cause the spire to be ablated during the laser re-doping for the emitter, and can easily damage the P-N junction, resulting in an increase in leakage current. When h1<2.5 µm, the height of the first textured surface 1 is too low, which will increase the recombination on the surface of the silicon wafer 100, and affect the photoelectric conversion efficiency of the cell. Therefore, when 2.5 µm≤h1≤3.5 µm, the lightly diffused sheet resistance is increased, the recombination on the surface of the silicon wafer 100 is reduced, and the short-circuit current is increased, thereby improving the photoelectric conversion efficiency of the cell.

Optionally, the thickness h2 of the second textured surface 4 in the first direction can be 2.5 µm, 2.6 µm, 2.7 µm, 2.8 µm, 2.9 µm, 3.0 µm, 3.1 µm, 3.2 µm, 3.3 µm, 3.4 µm, or 3.5 µm. When h2>3.5 µm, the height of the second textured surface 4 is excessively large, which can easily cause the spire to be ablated during the laser re-doping for the emitter, and can easily damage the P-N junction, resulting in an increase in leakage current. When h2<2.5 µm, the height of the second textured surface 4 is too low, which will increase the recombination on the surface of the silicon wafer 100, and affect the photoelectric conversion efficiency of the cell. Therefore, when 2.5 µm≤h2≤3.5 µm, the lightly diffused sheet resistance is increased, the recombination on the surface of the silicon wafer 100 is reduced, and the short-circuit current is increased, thereby improving the photoelectric conversion efficiency of the cell.

Optionally, the thickness h3 of the third textured surface 10 in the first direction can be 3.0 µm, 3.1 µm, 3.2 µm, 3.3 µm, 3.4 µm, 3.5 µm, 3.6 µm, 3.7 µm, 3.8 µm, 3.9 µm, or 4.0 µm. When h3>4.0 µm, the height of the third textured surface 10 is excessively large, which can easily cause the spire to be ablated during the laser re-doping for the emitter, and can easily damage the P-N junction, resulting in an increase in leakage current. When h3<3.0 µm, the height of the third textured surface 10 is too low, which will increase the recombination on the surface of the silicon wafer 100, and affect the photoelectric conversion efficiency of the cell. Therefore, when 3.0 µm≤h3≤4.0 µm, the lightly diffused sheet resistance is increased, the recombination on the surface of the silicon wafer 100 is reduced, and the short-circuit current is increased, thereby improving the photoelectric conversion efficiency of the cell.

Optionally, the spire angle α of the first textured surface 1 can be 40°, 41°, 42°, 43°, 44°, or 45°. When α<40°, the spire and edges are relatively sharp, leading to dense dangling bonds, which decreases the lifetime of minority carriers, and affects the efficiency of the cell. When α>45°, the spire is relatively flat, leading to a relatively smooth textured surface, which is not conducive to the formation of boron diffused layer 2. Therefore, when 40°≤α≤45°, the spire angle is appropriate, facilitating the subsequent boron diffusion. The spire angle β of the second textured surface 4 can be 40°, 41°, 42°, 43°, 44°, or 45°. When β<40°, the spire and edges are relatively sharp, leading to dense dangling bonds, which decreases the lifetime of minority carriers, and affects the efficiency of the cell. When β>45°, the spire is relatively flat, leading to a relatively smooth textured surface. Therefore, when 40°≤β≤45°, the spire and edges are relatively gentle, leading to sparse dangling bonds, which improve the lifetime of minority carriers to a certain extent, and enhances the efficiency of the cell. The spire angle θ of the third textured surface 10 can be 45°, 46°, 47°, 48°, 49°, or 50°. When θ<45°, the spire and edges are relatively sharp, leading to dense dangling bonds, which decreases the lifetime of minority carriers, and is not conducive to the uniform distribution of the passivation layer 18, thereby affecting the passivation effect, reducing open-circuit voltage, and affecting the efficiency of the cell. When θ>50°, the spire is relatively flat, leading to a relatively smooth textured surface, which is not conducive to the formation of boron diffused layer 2. Therefore, when 40°≤θ≤45°, the spire angle is appropriate, which is conducive to the formation of the passivation layer 18 and enhances the passivation effect.

In some optional embodiments, a condition for S2: performing the boron diffusion on the back side 12 to form the boron diffused layer 2 and the borosilicate glass 3 includes a temperature of 950°C to 1000°C and a time period of 4000 seconds to 5000 seconds.

Optionally, the temperature for S2: performing the boron diffusion on the back side 12 to form the boron diffused layer 2 and the borosilicate glass 3 can be 950°C, 957°C, 960°C, 965°C, 970°C, 978°C, 980°C, 986°C, 990°C, 998°C, or 1000°C. When the temperature is less than 950°C, the temperature is too low, and thus the boron diffusion rate is low, resulting in low process efficiency. When the temperature is greater than 1000°C, the temperature is too high, and thus the diffusion rate is too fast, so that borane molecules can undergo a variety of gas-phase reactions, resulting in the generation of undesirable impurities in the sample after long-term diffusion. Therefore, when the temperature for S2: performing the boron diffusion on the back side 12 to form the boron diffused layer 2 and the borosilicate glass 3 is in a range from 950°C to 1000°C, the temperature is relatively reasonable, which appropriately increases the movement speed of borane molecules, thereby improving the diffusion coefficient and diffusion rate of borane, saving processing time, and enhancing efficiency.

Optionally, the time period for S2: performing the boron diffusion on the back side 12 to form the boron diffused layer 2 and the borosilicate glass 3 can be 4000 s, 4100 s, 4260 s, 4358 s, 4480 s, 4570 s, 4680 s, 4780 s, 4899 s, 4999 s, or 5000 s. When the time period for performing the boron diffusion on the back side 12 to form the boron diffused layer 2 and the borosilicate glass 3 is less than 4000 s, the time period is too short, and thus the boron ion diffusion is insufficient to form a sufficient P-N junction depth, which affects the performance of the cell, and weakens the ability of the cell to absorb light. The excessively short diffusion time period may also lead to uneven distribution of boron ions in the silicon wafer 100, which affects the photoelectric conversion efficiency of the cell. When the time period for performing the boron diffusion on the back side 12 to form the boron diffused layer 2 and the borosilicate glass 3 is greater than 5000 s, the time period is too long, which will cause the boron ions to diffuse too deeply into the silicon wafer 100, forming excessively deep p-n junctions and affecting the ability to absorb short-wavelength light; and which can also lead to an uneven distribution of boron ions in the silicon wafer 100, affecting the resistivity and the sheet resistance of the cell, thereby impacting the photoelectric conversion efficiency of the cell. Therefore, when the time period for performing the boron diffusion on the back side 12 to form the boron diffused layer 2 and the borosilicate glass 3 is in a range from 4000 s to 5000 s, the diffusion depth of boron ions is appropriate, facilitating to improve the photoelectric conversion efficiency of the cell.

In some optional embodiments, the boron diffused layer 2 has a thickness of 700 nm to 1000 nm in the first direction y; and the borosilicate glass 3 has a thickness of 100 nm to 150 nm in the first direction y.

Optionally, the thickness of the boron diffused layer 2 in the first direction y can be 700 nm, 710 nm, 723 nm, 735 nm, 748 nm, 750 nm, 756 nm, 767 nm, 778 nm, 789 nm, 800 nm, 845 nm, 856 nm, 887 nm, 900 nm, 968 nm, or 1000 nm. When the thickness of the boron diffused layer 2 in the first direction y is less than 700 nm, the thickness of the boron diffused layer 2 is excessively thin, which may compromise its desired physical and chemical properties, such as hardness, wear resistance, corrosion resistance, etc. An excessively thin boron diffused layer 2 may be fragile and prone to be ruptured, reducing the lifetime and reliability of the boron diffused layer 2. The excessively thin boron diffused layer 2 may lead to deterioration of characteristics of the P-N junctions, affecting the photoelectric conversion efficiency of solar cells. When the thickness of the boron diffused layer 2 in the first direction y is greater than 1000 nm, the boron diffused layer 2 is excessively thick, which can lead to increased internal stress within the material, affecting the stability, the flatness, and the processing performance of the material. Therefore, when the thickness of the boron diffused layer 2 in the first direction y is in a range from 700 nm to 1000 nm, the thickness of the boron diffused layer 2 is moderate, which can enhance the conversion efficiency of the cell, optimize passivation performance, and improve stability of the cell.

Optionally, the thickness of the borosilicate glass 3 in the first direction y can be 100 nm, 110 nm, 125 nm, 132 nm, 145 nm, or 150 nm. When the thickness of the borosilicate glass 3 in the first direction y is less than 100 nm, the borosilicate glass 3 is relatively thin, which can diminish the protective effect on the boron diffused layer 2 in the first region 16 during laser grooving for formation of the localized emitter, thereby damaging the emitter. When the thickness of the borosilicate glass 3 in the first direction y is greater than 150 nm, the borosilicate glass 3 is relatively thick, leading to an incomplete removal during cleaning by the third double-sided texturing, and thus affecting performance of the cell. Therefore, when the thickness of the borosilicate glass 3 in the first direction y is in a range from 100 nm to 150 nm, the thickness is moderate, which can ensure that the boron diffused layer 2 in the first region 16 is not damaged during the laser grooving, and the borosilicate glass 3 can be effectively removed during cleaning.

In some optional embodiments, a condition for performing the phosphorus diffusion on the front side 11 to form the phosphorus diffused layer 13 and the phosphorosilicate glass 6 includes a temperature of 900°C to 950°C and a time period of 3000 seconds to 4000 seconds; a thickness of the phosphorosilicate glass 6 in the first direction y is in a range from 60 nm to 100 nm; a thickness of the phosphorus diffused layer 13 in the first direction y is in a range from 600 nm to 1000 nm.

Optionally, the temperature for performing the phosphorus diffusion on the front side 11 to form the phosphorus diffused layer 13 and the phosphorosilicate glass 6 can be 900°C, 910°C, 923°C, 928°C, 934°C, 938°C, 943°C, 948°C, or 950°C. When the temperature is lower than 900°C, the temperature of phosphorus diffusion is too low to form a uniform phosphorus diffused layer 13, which affects the performance of the material. Since the phosphorus diffusion is an endothermic reaction, when the temperature is too low, the necessary heat is not adequately compensated, resulting in a slow film formation rate. When the temperature exceeds 950°C, the temperature is excessively high, so that the phosphorus diffused layer 13 may form too quickly and be excessively thick, leading to deformation. Therefore, when the temperature is in a range from 900°C to 950°C, the formed phosphorus diffused layer 13 and the phosphorosilicate glass 6 are relatively stable, with an appropriate diffusion depth.

Optionally, the time period for performing the phosphorus diffusion on the front side 11 to form the phosphorus diffused layer 13 and the phosphorosilicate glass 6 can be 3000 s, 3168 s, 3280 s, 3360 s, 3480 s, 3560 s, 3680 s, 3760 s, 3853 s, 3967 s, or 4000 s. When the time period for performing the phosphorus diffusion on the front side 11 to form the phosphorus diffused layer 13 and the phosphorosilicate glass 6 is less than 3000 s, it may lead to incomplete phosphorization reactions and cause insufficient phosphorus diffusion, which affects the conductivity of the cell, and causes the phosphorus diffused layer 13 and the phosphorosilicate glass 6 to be thin, thereby affecting the passivation effect. When the time period for performing the phosphorus diffusion on the front side 11 to form the phosphorus diffused layer 13 and the phosphorosilicate glass 6 is greater than 4000 s, the phosphorus diffused layer 13 and the phosphorosilicate glass 6 may have rough textures with coarse crystal nuclei and large pores, thereby affecting the corrosion resistance and stability. The excessively long time period may cause the phosphorus diffused layer 13 and the phosphorosilicate glass 6 to be too thick, which may hinder the absorption and transmission of photons, impacting cell efficiency, and increasing production costs. Therefore, when the time period for performing the phosphorus diffusion on the front side 11 to form the phosphorus diffused layer 13 and the phosphorosilicate glass 6 is in a range from 3000 s to 4000 s, the time period of phosphorus diffusion on the front side 11 is appropriate, which allows the formation of the phosphorus diffused layer 13 and the phosphorosilicate glass 6 layer with suitable thicknesses, improving cell efficiency and saving costs.

Optionally, the thickness of the phosphosilicate glass 6 in the first direction y can be 60 nm, 65 nm, 68 nm, 71 nm, 75 nm, 79 nm, 80 nm, 83 nm, 86 nm, 90 nm, 93 nm, 95 nm, 98 nm, or 100 nm. When the thickness of the phosphosilicate glass 6 in the first direction y is less than 600 nm, the excessively thin phosphosilicate glass 6 layer may fail to provide sufficient passivation effect, resulting in decreased cell performance and decreasing the open-circuit voltage and short-circuit current of the cell; and it also fails to protect the phosphorus diffused layer or the doped polysilicon layer 7 in the first region 16 during the laser grooving. When the thickness of the phosphosilicate glass 6 in the first direction y is greater than 1000 nm, the relatively thick phosphosilicate glass 6 layer can increase the light reflection, thereby reducing the absorption of the silicon wafer 100 to light, and decreasing the optical performance of the cell. The phosphosilicate glass 6 inherently has a certain resistivity, and the relatively thick phosphosilicate glass 6 layer can increase the internal resistance of the cell, resulting in a decrease in fill factor, thereby reducing the efficiency of the cell. Therefore, when the thickness of the phosphosilicate glass 6 in the first direction y is in a range from 600 nm to 1000 nm, the phosphorous diffusion layer 13 or the doped polysilicon layer 7 in the first region 16 can be protected from damage.

Optionally, the thickness of the phosphorus diffused layer 13 in the first direction y can be 600 nm, 650 nm, 678 nm, 710 nm, 756 nm, 790 nm, 800 nm, 830 nm, 868 nm, 900 nm, 935 nm, 957 nm, 988 nm, or 1000 nm. When the thickness of the phosphorus diffused layer 13 in the first direction y is less than 600 nm, the excessively thin phosphorus diffused layer 13 may result in poor phosphorization effect and causes the phosphorus diffusion role unable to be fully achieved. The excessively thin phosphorus layer may make the performance of the material unstable. When the thickness of the phosphorus diffused layer 13 in the first direction y is greater than 1000 nm, the excessively thick phosphorus diffused layer 13 may cause the material to be brittle and reduce the mechanical strength of the material, which can affect its photoelectric conversion efficiency, lead to degradation of performance, and increase production costs. Therefore, when the thickness of the phosphorus diffused layer 13 in the first direction y is in a range from 600 nm to 1000 nm, the phosphorus diffused layer 13 has strong stability and stable photoelectric conversion efficiency.

In some optional embodiments, S4: depositing polysilicon on the front side 11, followed by S5: performing phosphorus diffusion to form the doped polysilicon layer 7 and the phosphorosilicate glass 6 includes steps of:
depositing a polysilicon layer 5 on the front side 11, and
performing the phosphorus diffusion to form the doped polysilicon layer 7 and the phosphorosilicate glass 6.

A condition for depositing the polysilicon layer 5 on the front side 11 includes a time period of 300 seconds to 360 seconds and a temperature of 600°C to 650°C. A thickness of the polysilicon layer 5 in the first direction y is in a range from 140 nm to 155 nm.

A thickness of the doped polysilicon layer 7 in the first direction y is in a range from 130 nm to 150 nm.

It should be noted that, the polysilicon layer 5 can be deposited on the front side 11 by using a low-pressure chemical vapor deposition method.

Optionally, the time period for depositing the polysilicon layer 5 on the front side 11 can be 300 s, 310 s, 315 s, 320 s, 335 s, 343 s, 350 s, 353 s, or 360 s. When the time period for depositing the polysilicon layer 5 on the front side 11 is less than 300 s, it may result in incomplete deposition of the polysilicon layer 5, forming a nonuniform layer structure. This nonuniformity may affect the performance of the cell, such as reducing the conversion efficiency, increasing the resistance, etc. When the time period for depositing the polysilicon layer 5 on the front side 11 is greater than 360 s, it may increase production costs because more energy and raw materials are required. Excessive deposition duration may result in an excessively thick polysilicon layer 5. Therefore, when the time period for depositing the polysilicon layer 5 on the front side 11 is in a range from 300 s to 360 s, the deposited polysilicon layer 5 has good uniformity, with reasonable costs and improved performance of the cell.

Optionally, the temperature for depositing the polysilicon layer 5 on the front side 11 can be 600°C, 603°C, 607°C, 610°C, 612°C, 617°C, 620°C, 625°C, 628°C, 630°C, 638°C, 640°C, 645°C, or 650°C. When the temperature for depositing the polysilicon layer 5 on the front side 11 is less than 600°C, the chemical reaction rate may be slowed down, leading to a decreased deposition rate and increased production time. Low temperatures may also affect the crystallinity and purity of the polysilicon layer 5, and in turn affect the performance of the cell. When the temperature for depositing the polysilicon layer 5 on the front side 11 is greater than 650°C, the chemical reaction may be accelerated. However, the excessively high temperature may increase the thermal stress in the silicon wafer 100, thereby causing deformation or crack. The high temperature may also cause surface oxidation or other chemical reactions, affecting the performance of the cell. Therefore, when the temperature for depositing the polysilicon layer 5 on the front side 11 is in a range from 600°C and 650°C, the temperature is suitable, which can ensure the deposition efficiency and does not affect the performance of the cell.

Optionally, the thickness of the polysilicon layer 5 in the first direction y can be 140 nm, 141 nm, 142 nm, 143 nm, 144 nm, 145 nm, 146 nm, 147 nm, 148 nm, 149 nm, 150 nm, 151 nm, 152 nm, 153 nm, 154 nm, or 155 nm. When the thickness of the polysilicon layer 5 in the first direction y is less than 140 nm, it may deteriorate the interface passivation effect, reducing the conversion efficiency of the cell. Moreover, the thin polysilicon layer 5 may not be sufficient to effectively block the recombination of carriers, thereby decreasing the performance of the cell. When the thickness of the polysilicon layer 5 in the first direction y is greater than 155 nm, the excessively thick polysilicon layer 5 may increase optical loss and also increase the thermal stress of the cell, thereby affecting the long-term stability of the cell. Therefore, when the thickness of the polysilicon layer 5 in the first direction y is in a range from 140 nm to 155 nm, the thickness is moderate, which not only ensures passivation effect and effectively block recombination of carriers, but also does not increase optical loss, thereby ensuring the stability of the cell.

Optionally, the thickness of the doped polysilicon layer 7 in the first direction y can be 130 nm, 132 nm, 134 nm, 135 nm, 138 nm, 140 nm, 142 nm, 145 nm, 148 nm, or 150 nm. When the thickness of the doped polysilicon layer 7 in the first direction y is less than 130 nm, the thickness of the doped polysilicon layer 7 is excessively thin, which may increase the gold semi-contact resistivity, and affect the current transmission efficiency, thus reducing the fill factor (FF) and the open-circuit voltage (Voc) of the cell. When the thickness of the doped polysilicon layer 7 in the first direction y is greater than 150 nm, the doped polysilicon layers 7 is excessively thick, which may absorb more incident light and reduce the number of photons reaching the interior of the solar cell, thereby affecting the short-circuit current density (Jsc) of the cell. The relatively thick doped polysilicon layers 7 exhibits a more pronounced temperature rise at the reverse bias voltage, thereby increasing the risk and severity of hot spots. The increase in thickness also means an increase in material costs. Therefore, when the thickness of the doped polysilicon layer 7 in the first direction y is in a range from 130 nm to 150 nm, the thickness is suitable, which can ensure the conversion efficiency of the cell, improve the open-circuit voltage and the short-circuit current, save certain costs, and improve the stability.

In some optional embodiments, S6: laser grooving to form the localized emitter includes steps of:
S61: applying laser to the front side, and
S62: applying laser to the back side.

The silicon wafer 100 includes a first region 16 and a second region 17. Applying the laser to the front side 11 forms a doped polysilicon emitter 8 or a phosphorus diffused emitter 14 in the first region 16 of the front side 11. Applying the laser to the back side 12 forms a boron diffused emitter 9 in the first region 16 of the back side 12.

The first region 16 of the front side 11 occupies 3% to 30% of the front side 11. The first region 16 of the back side 12 occupies 5% to 50% of the back side 12.

It should be noted that the silicon wafer 100 includes the first region 16 and the second region 17. The first region 16 is a metallic region, and the second region 17 is a non-metallic region.

It should be noted that the implementation of the localized emitters facilitates the reduction of recombination induced by diffusion, thereby enhancing the open-circuit voltage of the cell. The smaller the area proportion of the emitter, the greater the effect on increasing the open-circuit voltage.

Optionally, the first region 16 of the front side 11 can occupy 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, or 30% of the front side 11. When the first region 16 of the front side 11 occupies less than 3% of the front side 11, the area of the first region 16 of the front side 11 is excessively small to effectively collect photogenerated carriers, leading to an increase in recombination, reducing fill factor and open-circuit voltage of the cell, thus decreasing the conversion efficiency of the cell. When the first region 16 of the front side 11 occupies greater than 30% of the front side 11, the area of the first region 16 of the front side 11 is excessively large, so that a relatively large localized emitter can block more light from entering the interior of the cell, thereby reducing the light absorption efficiency, leading to a decrease in short-circuit current density of the cell, and ultimately affecting the conversion efficiency of the cell. Therefore, when the first region 16 of the front side 11 occupies 3% to 30% of the front side 11, the localized emission electrode has a moderate size, improving the conversion efficiency and short-circuit current of the cell group.

Optional, the first region 16 of the back side 12 can occupy 5%, 9%, 10%, 15%, 18%, 22%, 25%, 28%, 30%, 35%, 38%, 39%, 40%, 43%, 46%, 48%, or 50% of the back side 12. When the first region 16 of the back side 12 occupies less than 5% of the back side 12, the boron diffused emitter 9 is excessively small, which may cause an uneven distribution of current density in the electrode, and result in a thermal effect in a region with a high current density, thereby affecting the long-term stability and reliability of the cell. Manufacturing of the localized emission electrode with an excessively small size may require relatively high precision and technical requirements, thereby increasing manufacturing difficulty and costs. When the first region 16 of the back side 12 occupies greater than 50% of the back side 12, the boron diffused emitter 9 occupies a large space, which can lead to an increase in series resistance inside the cell. The increased resistance can cause the cell to generate more heat during operation, thereby lowering the efficiency and stability of the cell. The large sized localized emission electrode is manufactured with more materials, which increases production costs. Therefore, when the first region 16 of the back side 12 occupies 5% to 50% of the back side 12, the space occupation proportion of the boron diffused emitter 9 in the cell is appropriate, which saves costs, maintains internal stability of the cell, and enhances the conversion efficiency of the cell.

In some optional embodiments, the double-sided rounding includes steps of:
cleaning the silicon wafer 100 in an ozone oxidation solution, and
cleaning the silicon wafer 100 in an acid washing solution.

A radius of curvature of the rounded-textured surface 15 is r, where 0.5 µm≤r≤1.2 µm.

It should be noted that, the spires and surfaces of the third textured surface 10 and the second textured surface 4 can be oxidized with the ozone oxidation solution. However, since the molecular free path decreases gradually from the spire to the bottom, the oxide layer formed from the spire to the bottom is gradually thinned. After removing the oxide layer via acid washing, a rounded-textured surface 15 that has been rounded is formed, which is closer to a flat surface structure, thereby benefiting to uniform deposition of the anti-reflection layer 19 and the passivation layer 18, and thus improving the passivation effect. Additionally, the rounded-textured surface significantly reduces light transmission inside the silicon substrate, enhances absorption of the cell to light, and improves generation of charge carriers.

Optionally, the radius r of curvature of the rounded-textured surface 15 can be 0.5 µm, 0.6 µm, 0.7 µm, 0.8 µm, 0.9 µm, 1.0 µm, 1.1 µm, or 1.2 µm. When the radius r of curvature of the rounded-textured surface 15 is less than 0.5 µm, the radius of curvature of the rounded-textured surface 15 is excessively small, which is not conducive to subsequent deposition of the passivation layer 18. When the radius r of curvature of the rounded-textured surface 15 is greater than 1.2 µm, the radius of curvature of the rounded-textured surface 15 is excessively large, almost equivalent to a flat surface, which reduces the light absorption capacity of the cell, because the light reflection of a flat surface is greater than that of a textured surface. Therefore, when the radius r of curvature of the rounded-textured surface 15 meets 0.5 µm≤r≤1.2 µm, it can not only promote the deposition of the passivation film layer thereon, ensuring the passivation effect, but also improve the ability of the cell to absorb light.

Based on the same concept of the present application, referring to FIGS. 1 to 5, the present application further provides a TOPCON cell prepared by the method for preparing the TOPCON cell as described above.

Optionally, the present application provides a TOPCON cell including the silicon wafer 100. The doped polysilicon emitter 8 is disposed in the first region 16 of the front side 11 of the silicon wafer 100, and the boron diffused emitter 9 is disposed in the first region 16 of the back side 12 of the silicon wafer 100. The surface of the doped polysilicon emitter 8 and the surface of the boron diffused emitter 9 are the second textured surfaces 4. In the second region 17, the surfaces of the front side 11 and the back side 12 of the silicon wafer 100 are the third textured surfaces 10. The cell further includes a passivation layer 18 and an anti-reflection layer 19.

Optionally, the present application provides another TOPCON cell including the silicon wafer 100. The phosphorus diffused emitter 14 is disposed in the first region 16 of the front side 11 of the silicon wafer 100, and the boron diffused emitter 9 is disposed in the first region 16 of the back side 12 of the silicon wafer 100. The surface of the phosphorus diffused emitter 14 and the surface of the boron diffused emitter 9 are the second textured surfaces 4. In the second region 17, the surfaces of the front side 11 and the back side 12 of the silicon wafer 100 are the third textured surfaces 10. The cell further includes the passivation layer 18 and the anti-reflection layer 19.

Optionally, the present application provides yet another TOPCON cell including the silicon wafer 100. The phosphorus diffused emitter 14 is disposed in the first region 16 of the front side 11 of the silicon wafer 100, and the boron diffused emitter 9 is disposed in the first region 16 of the back side 12 of the silicon wafer 100. The surface of the phosphorus diffused emitter 14 and the surface of the boron diffused emitter 9 are the rounded-textured surfaces 15. In the second region 17, the surfaces of the front side 11 and the back side 12 of the silicon wafer 100 are the rounded-textured surfaces 15. The cell further includes the passivation layer 18 and the anti-reflection layer 19.

It should be understood that the TOPCON cell provided in the present application can simultaneously significantly increase the open-circuit voltage, fill factor, and bifaciality factor.

**Table 1. Comparison of performance of TOPCON cells**

| | Open-circuit voltage | Fill factor | Cell conversion efficiency | Bifaciality factor |
|---|---|---|---|---|
| Control group | 730 mv | 85% | 26% | 72% |
| Experimental group | 740 mv | 85.5% | 28.2% | 92% |

The TOPCON cell prepared by the preparation method of the TOPCON cell provided in the present application includes the silicon wafer 100. The phosphorus diffused emitter 14 or the doped polysilicon emitter 8 is disposed in the first region 16 of the front side 11 of the silicon wafer 100, and the boron diffused emitter 9 is disposed in the first region 16 of the back side 12 of the silicon wafer 100. The surface of the emitter in the first region 16 is the second textured surface 4 or the rounded-textured surface 15. The surface of the second region 17 of the silicon wafer 100 is the third textured surface 10 or the rounded-textured surface 15. Exemplarily, the TOPCON cell provided in the present application is compared to the TOPCON cell prepared by the related technology, in which the related technology includes performing single-sided texturing on one side of the silicon wafer once by an alkali polishing process, and performing laser grooving in the first region by using a mask to form the emitter electrode.

The open-circuit voltage of the control group (i.e., the TOPCON cell prepared by the related technology) is 730 mv, and the open-circuit voltage of the experimental group (i.e., the TOPCON cell provided in the present application) is 740 mv. The fill factor of the control group (i.e., the TOPCON cell prepared by the related technology) is 85%, and the fill factor of the experimental group (i.e., the TOPCON cell provided in the present application) is 85.5%. The cell conversion efficiency of the control group (i.e., the TOPCON cell prepared by the related technology) is 26%, and the cell conversion efficiency of the experimental group (i.e., the TOPCON cell provided in the present application) is 28.2%. The bifaciality factor of the control group (i.e., the TOPCON cell prepared by the related technology) is 72%, and the bifaciality factor of the experimental group (i.e., the TOPCON cell provided in the present application) is 92%. Compared to those of the control group (i.e., the TOPCON cell provided in the present application), the open-circuit voltage, the fill factor, and the cell conversion efficiency of the experimental group (i.e., the TOPCON cell provided in the present application) are increased to a certain extent, and the bifaciality factor is significantly improved. To sum up, according to the TOPCON cell provided in the present application, the doped polysilicon emission electrode or the phosphorus diffused emission electrode is disposed on the front side 11, and the boron diffused emission electrode is disposed on the back side 12. The implementation of the localized emission electrodes helps to reduce the recombination caused by the diffusion layer, and improve the open-circuit voltage of the cell. The third textured surfaces 10 are formed on the front side 11 and the back side 12, and the double-sided textured surfaces further improve the bifaciality factor and save costs. Regarding the double-sided rounding, the rounded textured surfaces 15 are formed on the front side 11 and the back side 12, which improves the passivation effect, effectively reduces the light transmission inside the silicon wafer 100, and improves the light absorption capacity and carrier generation capacity of the cell, while improving the open-circuit voltage, the fill factor, the cell conversion efficiency, and bifaciality factor.

While some specific embodiments of the present application have been described in detail with reference to examples, it should be understood by those skilled in the art that, the above examples are only for illustrative purposes and are not intended to limit the scope of the present application.

## Claims

1. A method for preparing a TOPCON cell, comprising steps of:
providing a silicon wafer having a front side and a back side disposed opposite to each other in a first direction, the first direction being a thickness direction of the silicon wafer,
first double-sided texturing the silicon wafer to form first textured surfaces on the front side and the back side,
performing boron diffusion on the back side to form a boron diffused layer and a borosilicate glass,
second double-sided texturing the silicon wafer to form a second textured surface on the front side and the back side,
depositing polysilicon on the front side, followed by performing phosphorus diffusion to form a doped polysilicon layer and a phosphorosilicate glass, or directly performing phosphorus diffusion on the front side to form a phosphorus diffused layer and the phosphorosilicate glass,
laser grooving to form a localized emitter, and
third double-sided texturing the silicon wafer to remove the phosphorosilicate glass and the borosilicate glass and form third textured surfaces on the front side and the back side, or third double-sided texturing and double-sided rounding the silicon wafer to form rounded-textured surfaces on the front side and the back side.

2. The method for preparing the TOPCON cell according to claim 1, wherein a condition for the first double-sided texturing comprises a temperature of 65°C to 70°C and a time period of 350 seconds to 400 seconds.

3. The method for preparing the TOPCON cell according to claim 1 or 2, wherein a condition for the second double-sided texturing comprises a temperature of 65°C to 70°C and a time period of 350 seconds to 400 seconds.

4. The method for preparing the TOPCON cell according to any one of claims 1 to 3, wherein a condition for the third double-sided texturing comprises a temperature of 70°C to 75°C and a time period of 400 seconds to 450 seconds.

5. The method for preparing the TOPCON cell according to any one of claims 1 to 4, wherein the first textured surface has a thickness h1 in the first direction and a spire angle α, where 2.5 µm≤h1≤3.5 µm, and 40°≤α≤45°.

6. The method for preparing the TOPCON cell according to any one of claims 1 to 5, wherein the second textured surface has a thickness h2 in the first direction and a spire angle β, where 2.5 µm≤h2≤3.5 µm, and 40°≤β≤45°.

7. The method for preparing the TOPCON cell according to any one of claims 1 to 6, wherein the third textured surface has a thickness h3 in the first direction and a spire angle θ, where 3 µm≤h3≤4 µm, and 45°≤θ≤50°.

8. The method for preparing the TOPCON cell according to any one of claims 1 to 7, wherein a condition for performing the boron diffusion on the back side to form the boron diffused layer and the borosilicate glass comprises a temperature of 950°C to 1000°C and a time period of 4000 seconds to 5000 seconds.

9. The method for preparing the TOPCON cell according to any one of claims 1 to 8, wherein the boron diffused layer has a thickness of 700 nm to 1000 nm in the first direction; the borosilicate glass has a thickness of 100 nm to 150 nm in the first direction.

10. The method for preparing the TOPCON cell according to any one of claims 1 to 9, wherein a condition for performing the phosphorus diffusion on the front side to form the phosphorus diffused layer and the phosphorosilicate glass comprises a temperature of 900°C to 950°C and a time period of 3000 seconds to 4000 seconds;
a thickness of the phosphorosilicate glass in the first direction is in a range from 60 nm to 100 nm;
a thickness of the phosphorus diffused layer in the first direction is in a range from 600 nm to 1000 nm.

11. The method for preparing the TOPCON cell according to any one of claims 1 to 10, wherein depositing polysilicon on the front side, followed by performing phosphorus diffusion to form the doped polysilicon layer and the phosphorosilicate glass comprises steps of:
depositing a polysilicon layer on the front side, and
performing the phosphorus diffusion to form the doped polysilicon layer and the phosphorosilicate glass;
a condition for depositing the polysilicon layer on the front side comprises a time period of 300 seconds to 360 seconds and a temperature of 600°C to 650°C.

12. The method for preparing the TOPCON cell according to any one of claims 1 to 11, wherein a thickness of the polysilicon layer in the first direction is in a range from 140 nm to 155 nm;
a thickness of the doped polysilicon layer in the first direction is in a range from 130 nm to 150 nm.

13. The method for preparing the TOPCON cell according to any one of claims 1 to 12, wherein laser grooving to form the localized emitter comprises steps of:
applying laser to the front side, and
applying laser to the back side;
the silicon wafer comprises a first region and a second region; applying the laser to the front side forms a doped polysilicon emitter or a phosphorus diffused emitter in the first region of the front side; applying the laser to the back side forms a boron diffused emitter in the first region of the back side;
the first region of the front side occupies 3% to 30% of the front side; the first region of the back side occupies 5% to 50% of the back side.

14. The method for preparing the TOPCON cell according to any one of claims 1 to 13, wherein the double-sided rounding comprises steps of:
cleaning the silicon wafer in an ozone oxidation solution, and
cleaning the silicon wafer in an acid washing solution;
a radius of curvature of the rounded-textured surface is r, where 0.5 µm≤r≤1.2 µm.

15. A TOPCON cell prepared by the method for preparing the TOPCON cell according to any one of claims 1 to 14.
